# EUROPÄISCHE PATENTANMELDUNG

(11) **EP 1 022 099 A2**
(43) Veröffentlichungstag der Anmeldung: **26.07.2000**
(21) Anmeldenummer: 99121028.7
(22) Anmeldetag: 21.10.1999
(51) Int. Cl.: B25J 9/16, H05K 13/04

(54) **Verfahren und Greifersystem zur Durchführung des Verfahrens zur präzisen Handhabung und Montage von kleinen Bauteilen**

(30) Priorität: 28.10.1998 DE 19849720
(71) Anmelder: ROBERT BOSCH GMBH, 70442 Stuttgart (DE)
(72) Erfinder: Schreier, Kurt, Dipl.-Ing., 73614 Schorndorf (DE); Steegmueller, Bernd, Dipl.-Ing., 71711 Murr (DE); Hoehn, Michael, Dipl.-Ing., 85375 Neufahrn (DE)

(57) **Zusammenfassung**

Die Erfindung betrifft ein Verfahren zum präzisen Positionieren und Fügen eines Bauteils auf einer Fügeposition einer Montageebene mittels eines Handhabungsgerätes mit Grob-Positionierantrieb eines Greifsystems mit Fein-Positionierantrieb sowie eines Meß- und Auswertesystems zum Ermitteln der Fügeposition und der Bauteil-Position des vom Greifer des Greifersystems gehaltenen Bauteils, zum Berechnen einer Positionsabweichung zwischen Fügeposition und Bauteil-Position und damit eines Korrrekturwertes zum Steuern des Grob- und Fein-Positionierantriebs. Mit einer iteraktiven Grob-/Feinpositionierung wird mit einem Standard-Handhabungsgerät und einem zusätzlichen Präzisionsantrieb mit kleinem Stellweg und sehr hoher Positioniergenauigkeit ein hochpräzises Positionierverfahren geschaffen, wobei vorzugsweise ein besonders ausgerüstetes Greifersystem eingesetzt wird. Mit dem optischen System mit Kamera kann der gesamte Verfahrensablauf visuell beobachtet und kontrolliert werden.

## Beschreibung

### Stand der Technik

Die Erfindung betrifft ein Verfahren zum präzisen Positionieren und Fügen eines Bauteils auf einer Fügeposition einer Montageebene mittels eines Handhabungsgerätes mit Grob-Positionierantrieb eines Greifsystems mit Fein-Positionierantrieb sowie eines Meß- und Auswertesystems zum Ermitteln der Fügeposition und der Bauteil-Position des vom Greifer des Greifersystems gehaltenen Bauteils, zum Berechnen einer Positionsabweichung zwischen Fügeposition und Bauteil-Position und damit eines Korrrekturwertes zum Steuern des Grob- und Fein-Positionierantriebs.

Bei der heutigen Robot-Vision-Applikation, wie sie z.B. bei Bestückungsautomaten angewendet wird, sind die bildgebenden Sensoren in der Regel exzentrisch zur Fügeachse angeordnet. Diese Technik führt zu einer Trennung von Bildaufnahme- und Fügeposition. Daher kann die Positionskorrekturbewegung nach der Bildaufnahme nicht vom Vision-System überwacht werden (gesteuerte, bildverarbeitungsbasierte Positionierung). Zur Positionierung des Bauteils muß dessen Position am Greifer bekannt sein (passive oder optische Zentrierung) und die Lage des Bildkoordinatensystems zum Handhabungsgerätesystem vor dem Montageablauf ermittelt werden. Zur Bestimmung der aus den Einzeltoleranzen (Greifertoleranzen, Bereitstellungstoleranzen usw.) resultierenden Positionsabweichung sind in der Regel mehrere, aufeinanderfolgende Meßschritte (Vermessung der Position des gegriffenen Bauteils, Vermessung der Fügeposition) notwendig, wodurch Taktzeit, Kosten (mehrere Kameras) und Genauigkeit (Korrelation der Sensordaten verschiedener Kameras, Kalibrierfehler) negativ beeinflußt werden. Die Endpositioniergenaugkeit wird neben der Meßgenauigkeit der Bildverarbeitung von der Genauigkeit der Kamerakalibrierung und der absoluten Positioniergenauigkeit des Handhabungsgerätes begrenzt.

Die automatisierte Montage von Mikrosystemen (kleinen Bauteilen) erfordert hochgenaue Positionierverfahren, die in der Lage sind, aus Handhabungs- (Bereitstellungs- und Greifertoleranzen) und Bauteiltoleranzen resultierende Positionierungsfehler zwischen den Montagepartnern zu erfassen und zu kompensieren.

Es ist Aufgabe der Erfindung, ein Verfahren der eingangs erwähnten Art zu schaffen, das unter Berücksichtigung aller auftretenden Toleranzen eine visuelle Positionskontrolle des Greif- und Montageablaufes mittels Bildverarbeitung ermöglicht, ohne dafür sehr teure Handhabungsspezialgeräte hoher Einstellgenauigkeit einsetzen zu müssen.

Dieses Verfahren ist nach der Erfindung dadurch gekennzeichnet, dass als Meß- und Auswertesystem eine Kamera mit Meßobjektiv und eine Bildverarbeitungseinrichtung verwendet wird, wobei die Kamera und das Meßobjektiv außerhalb der Fügeposition und Bauteil-Position angeordnet werden, dass Füge- und Bauteil-Position entweder gleichzeitig oder nacheinander im Tiefenschärfebereich das Meßobjektes abgebildet und gemessen werden, wobei bei der nacheinander erfolgenden Abbildung und Messung das optische System zwischen den Messungen ortsfeset in der gleichen Meßebene in Bezug auf die erste Messung verbleibt, dass bei einem ermittelten Korrekturwert gleich oder größer als der maximale Stellweg des Fein-Positionsantriebes bei stillstehendem Fein-Positionierantrieb durch den Grob-Positionierantrieb des Handhabungsgerätes eine Lagekorrektur vorgenommen wird, bis eine verbleibende Positionierabweichung kleiner als der maximale Stellweg des Fein-Positionierantriebes erreicht ist, dass nach Erreichen dieser verbleibenden Positionsabweichung durch den Fein-Positionierantrieb eine Endlagekorrektur mit einer zulässigen Fügetoleranz durchgeführt wird und dass danach der Fügevorgang eingeleitet und ausgeführt wird.

Mit dem zusätzlichen Präzisionsantrieb im Greifersystem kann ein handelsübliches Handhabungsgerät verwendet werden, da die hochpräzise Positionierung durch eine Aufteilung der Positionierbewegung in eine Grobkorrektur über das Handhabungsgerät und eine Feinkorrektur über den Präzisionsantrieb des Greifersystems vorgenommen wird. Dabei kann die Positionsabweichung mittels der Bildverarbeitungseinrichtung auch mehrmals erfaßt und die Korrekturbewegung entsprechend über das Handhabungsgerät und/oder den Präzisionsantrieb nachkorregiert werden, bis die bestimmte Positioniergenauigkeit erreicht ist (iteraktives Verfahren). Die Endpositioniergenauigkeit hängt nicht mehr von der Absolutgenauigkeit sondern von der wesentlich besseren Auflösung der Korrekturbewegung ab. Um die Auflösung der Korrekturbewegung und damit die Positioniergenauigkeit zu erhöhen, erfolgt die Positionierbewegung zur Kompensation der mit der Bildverarbeitungseinrichtung gemessenen Positionsabweichung nach einer Grob-/Feinpositionierstrategie. Dabei übernimmt das übergeordnete Handhabungsgerät die Grobpositionierung und der Präzisionsantrieb die Feinpositionierung in der unmittelbaren Nähe des Fügeortes durch den zusätzlichen hochauflösenden Präzisionsantrieb im Greifersystem. Diese Aufteilung der Positionierbewegung bietet den Vorteil, dass hochpräzise Montageaufgaben auch mit relativ ungenauen aber kostengünstigen und flexibel einsetzbaren Standard-Handhabungsgeräten (z.B. Industrieroboter, Low-Cost-Achssystemen) durchgeführt werden können. Ist die geforderte Positioniergenauigkeit erreicht, dann kann der Fügeprozeß in z-Richtung eingeschaltet werden. Der gesamte Verfahrensablauf kann über das optische System mit der Kamera beobachtet und notfalls in diesen eingegriffen werden.

Nach jeder Verstellung des Handhabungsgerätes oder des Präzisionsantriebes wird die Positionierabweichung ermittelt und davon abhängig das Handhabungsgerät erneut oder der Präzisionsantrieb entsprechend verstellt oder der Fügeprozeß eingeleitet.

Als Handhabungsgerät wird nach einer Ausgestaltung ein Handhabungsgerät mit einer in drei Koordination (x, y, z) verstellbaren und in der Winkelstellung (φ) veränderbaren Verstelleinrichtung eingesetzt, die einen großen Stellweg, jedoch eine kleine Einstellgenauigkeit aufweist.

Als Präzisionsantrieb im Greifersystem wird nach einer Ausgestaltung ein Präzisionsantrieb mit einer in drei Koordinaten (x, y, z) verstellbaren Präzisionsverstelleinrichtung mit kleinem Stellweg, jedoch großer Verstellgenauigkeit eingesetzt.

Ist nach einer weiteren Ausgestaltung vorgesehen, dass über das mit einer Kamera versehene optische System des Greifersystems sowohl die Position des Bauteils als auch die Fügeposition auf der Montageebene gleichzeitig oder nacheinander erfaßt werden und dass mittels der Bildverarbeitungseinrichtung aus den beiden Bildern der vorzunehmende Korrekturweg errechnet wird, dann kann im Sichtfeld der Kamera das Bauteil und der Fügeort auf der Montageebene gleichzeitig oder direkt nacheinander beobachtet und direkt die relative Positionsabweichung gemessen werden. Dies kann entweder durch die zentrische Integration der Kamera in das Greifersystem oder durch die exzentrische Gestaltung eines in das Kamerasichtfeld hineinragenden Greifer realisiert werden.

Die Positionsabweichung zwischen dem gegriffenen Bauteil und dem Fügeort kann auch aus zwei nacheinander aufgenommenen Bildern bestimmt werden. Dies kann z.B. erforderlich sein, wenn bei geringer Tiefenschärfe des verwendeten optischen Systems nacheinander auf die in veschiedenen Schärfeebenen liegenden Teile fokussiert werden muß oder wenn das gegriffene Bauteil zur Vermessung der darunterliegenden Fügeposition aus dem Sichtfeld der Kamera gezogen werden muß.

Da bei dem erfindungsgemäßen Verfahren sowohl das Bauteil am Greifer als auch dessen Fügeposition in einem gemeinsamen Kamerasichtfeld betrachtet werden können, ermöglicht diese Vorgehensweise eine direkte Bestimmung der Positionsabweichung und eine Kontrolle der durchgeführten Positionskorrektur mittels Bildverarbeitung. Falls erforderlich, wird die nach einer Korrekturbewegung verbleibende Positionsabweichung erneut bestimmt und eine weitere Grob- und/oder Feinkorrektur durchgeführt, bis die geforderte zulässige Fügetoleranz eingehalten ist. Dieses geregelte Positionierverfahren ermöglicht es also, das Bauteil schrittweise (iterativ) und hochpräzise der Fügeposition über dem Fügeort anzunähern. Bei kleinen Schritten der Verstellbewegung fließt nicht mehr die Absolutgenauigkeit, sondern die wesentlich präzisere Auflösung der Korrekturbewegung und die Kalkulation des Endpositionierfehlers ein, wodurch die höhere Positioniergenauigkeit erreicht wird.

Die Erfassung des Fügeortes wird dadurch erleichtert, dass die Fügeposition aus Markierungen der Montageebene ermittelt wird, die das Bauteil am Fügeort gleichförmig umschließen. Das gegriffene Bauteil verdeckt diese Markierungen dann nie vollständig, so dass während des gesamten Positionierungsvorganges der Fügeort beobachtet und erfaßt werden kann.

Ist eine Veränderung der Winkelstellung des Bauteils in der Montageebene erforderlich, dann ist nach einer Weiterbildung vorgesehen, dass die Winkelstellung des Bauteils über die Verstelleinrichtung des Handhabungsgerätes eingestellt wird. Die Einstellgenauigkeit in dieser Richtung des Handhabungsgerätes reicht in der Regel aus.

Für den Fügeprozeß nach dem Erreichen der Endpositionierung des Bauteils ist vorgesehen, dass der Fügeprozeß mittels eines Kraftsensors im Greifersystem kraftgesteuert durchgeführt und beim Erreichen oder Überschreiten einer vorgegebenen Fügekraft beendet wird.

Für den Fügeprozeß ist zudem vorgesehen, dass die Verstellung des Bauteils in z-Richtung mittels eines z-Achsen-Feinantriebs in kleinen Zustellinkrementen schrittweise vorgenommen wird sowie dass der Fügeprozeß bei stillstehendem Handhabungsgerät von dem in das Greifersystem integrierten z-Achsen-Feinantrieb ausgeführt wird.

Das Greifersystem zur Durchführung des Verfahrens ist dadurch gekennzeichnet, dass es ein Anschlußelement am Verbinden mit einem Handhabungsgerät aufweist, an dem der Präzisionsantrieb angebracht ist und dass in Richtung zum Greifer auf die Mittelachse des Greifers ausgerichtet eine Kamera, ein Objektiv mit manueller Fokussiereinrichtung, der Kraftsensor und eine weitere Fokussiereinrichtung angeordnet sind.

Da die Kamera und der Präzisionsantrieb in den Greifer integriert sind, können auch temperaturabhängige Verlagerungen des Handhabungegerätes kompensiert werden. Durch die Ausrichtung der Einrichtungen im Greifer auf dessen Mittelachse wird eine zusätzliche Ausrichtung auf die Fügeachse erreicht, die das Beobachten des Handhabungs- und Montageablaufs sowie die Erfassung der Positionen von Bauteil und Fügeort erleichtert. Dabei ist vorzugsweise vorgesehen, dass in das Objektiv koaxial Licht einer Lichtquelle eingeführt ist.

Ist nach einer Weiterbildung vorgesehen, dass der Greifer als Sauggreifer ausgebildet ist, der mit einem Glaseinsatz versehen und in der weiteren Fokussiereinrichtung eingebaut ist, dann ist auch im Sichtfeld das Bauteil in seiner Position zu sehen und in eine Fokussierebene einzustellen.

Als Präzisionsantrieb ist in das Greifersystem ein x, y, z-Piezoantrieb eingesetzt, während für die Kamera eine 1/3"-Miniaturkamera verwendet wird, deren Ausgangssignal der Bildverarbeitungseinrichtung mit der Steuerung zugeführt werden.

Weitere vorteilhafte Ausgestaltung sind den Unteransprüchen entnehmbar.

Die Erfindung wird anhand eines in den Zeichnungen dargestellten Ausführungsbeispiels näher erläutert. Es zeigen:
- Fig. 1: ein Diagramm für den Positionierablauf,
- Fig. 2: ein Diagramm für den Fügeprozeß,
- Fig. 3: die Schritte des iteraktiven Einstellvorganges und

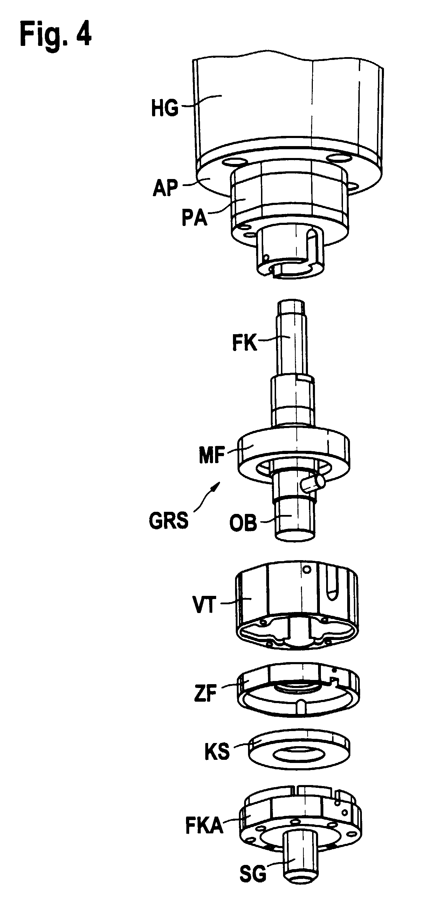

- Fig. 4: in Explosionsdarstellung ein Greifsystem mit Präzisionsantrieb, Kamera, optischem System und Kraftsensor zur Durchführung des erfindungsgemäßen Verfahrens.

Zur Durchführung eines Positionierverfahrens nach der Erfindung wird ein Standard-Handhabungsgerät HG benötigt, an dem ein Greifersystem GRS mit einem zusätzlichen Präzisionsantrieb PA angebracht ist. Das Greifersystem ist als Greifer mit einem optischen System ausgebildet, dem eine Kamera FK mit Bildverarbeitungseinrichtung BVE mit nachgeordneter Steuerung für das Handhabungsgerät HG und, den Präzisionsantrieb PA zugeordnet ist. Der konstruktive Aufbau des Greifersystems GRS wird später in Einzelheiten erläutert.

Das Handhabungsgerät HG hat einen verhältnismäßig großen Stellbereich, jedoch eine für eine Präzisionspositionierung ungenügende Positioniergenauigkeit, während der Präzisionsantrieb PA einen eng begrenzten Stellbereich jedoch eine sehr hohe Positionierungsgenauigkeit aufweist. Mit dem Handhabungsgerät HG kann in drei Koordinaten x, y und z verstellt und die Winkelstellung φ verändert werden, während der Präzisionsantrieb PA eine Verstellung mit x-, y- und z-Richtung ausführen kann.

Zur Durchführung der Positionskorrektur muß lediglich die Verdrehung zwischen dem im Greifersystem GRS integrierten Kamera-Koordinatensystems und dem Handhabungsgeräte-Koordinaten-System grob bestimmt werden, was die Kalibrierung erheblich vereinfacht. Kalibrierfehler können während der iteraktiven Positionierung erfaßt werden, wodurch stets eine Aktualisierung der Kalibrierdaten zur Erzielung einer höchstmöglichen Genauigkeit möglich ist. Die Endpositioniergenauigkeit hängt nicht von der Genauigkeit der Kamerakalibrierung ab. Zur Kalibrierung ist kein aufwendiges Kalibriernormal erforderlich, die Kalibrierung kann direkt am Bauteil vorgenommen werden und vollständig automatisch ablaufen.

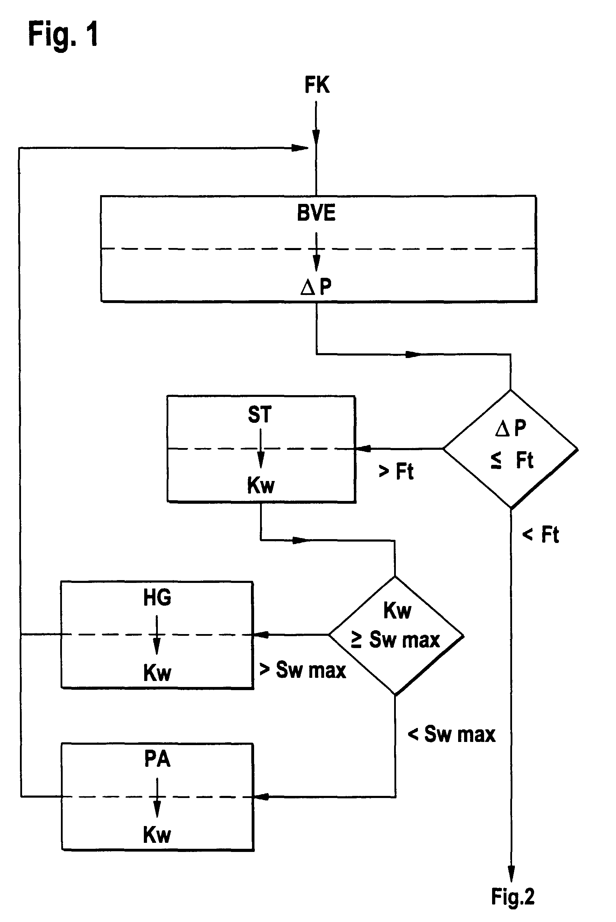

Wie Fig. 1 zeigt, erfolgt mit dem Start der Positionierung über die Kamera FK die Aufnahme von zwei Bildern, die einmal die Position des gegriffenen Bauteils BT und zum anderen die Position des Fügeortes auf der Montageebene ME zeigen. Dabei werden diese Positionen als Koordinatenwerte in der Bildverarbeitungseinrichtung BVE abgeleitet und die Positionsabweichung ΔP ebenfalls in Koordinatenwerte ermittelt. Ist die Positionsabweichung ΔP ≤ als die Fügetoleranz Ft, dann kann direkt der Fügeprozeß eingeleitet werden. Ist die Positionsabweichung ΔP größer als die zulässige Fügetoleranz Tf, dann muß eine Positionskorrektur durchgeführt werden. In der Steuerung ST wird aus der Positionsabweichung ΔP ein Korrekturweg Kw errechnet, der die Verstellwege in den Koordinatenrichtungen angibt. Der Präzisionsantrieb PA des Greifersystems GRS hat einen maximalen Stellweg Swmax. Ist der durchzuführende Korrekturwert Kw größer als der maximale Stellweg Swmax des Präzisionsantriebs PA, dann wird bei stillstehendem Präzisionsantrieb PA das Handhabungsgerät HG angesteuert, das mit seiner Stelleinrichtung den Korrekturweg ausführt. Liegt der Korrekturweg über dem maximalen Stellweg des Handhabungsgerätes HG, dann wird zunächst die maximal mögliche Korrektur ausgeführt und danach erneut die Positionsabweichung ΔP ermittelt, ein neuer Korrekturweg errechnet und ausgeführt. Dieser Vorgang wiederholt sich solange, bis nach der Einstellung des Handhabungsgerätes HG der nachfolgend festgestellte Korrekturweg Kw gleich oder kleiner ist als der maximale Stellweg des Präzisionsantriebs PA. Dann wird der Präzisionsantrieb PA angesteuert und mit der Präzisionsverstelleinrichtung des Greifersystems GRS wird der Korrekturweg Kw bei stillstehendem Handhabungsgerät HG ausgeführt, bis die Fügeposition mit der zulässigen Fügetoleranz Ft eingestellt ist. Mit der abschließenden Feststellung der Positionsabweichung ΔP ≤ der Fügetoleranz Ft wird der Fügeprozeß eingeleitet. Zu beachten ist, dass mit dem Korrekturweg Kw stets alle zu verändernden Koordinaten gemeint ist. Dies umfaßt in der Regel zumindest die Korrektur in x-, y-Richtung sowie in der Dreh-Winkelstellung φ.

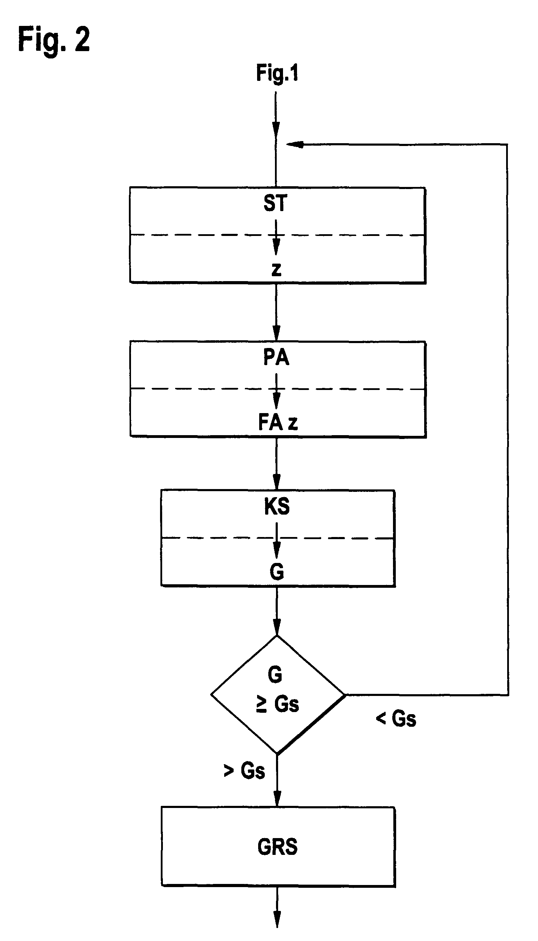

Der Fügeprozeß umfaßt, wie Fig. 2 zeigt, in der Regel zumindest die Verstellung des Präzisionsantriebes PA in z-Richtung. Das Handhabungsgerät HG ist vorher schon bei der Kalibrierung in der z-Richtung eingestellt worden.

Erhält die Steuerung ST das Fügesignal, dann wird der Verstellweg in z-Richtung berechnet. Der Präzisionsantrieb PA weist einen z-Achsen-Feinantrieb FA auf, der die Verstellung in z-Richtung in kleinen Zustellinkrementen schrittweise ausführt. Dabei wird mittels eines Kraftsensors KS das Kraftsignal G ausgewertet. Ist das Kratfsignal G kleiner als ein vorgegebener Schwellwert Gs, dann wird über die Steuerung ST und den Präzisionsantrieb PA die Zustellung in z-Richtung solange weitergeführt, bis der Schwellwert Gs erreicht oder überschritten ist.

Dann wird der Greifer GR des Greifersystems GRS gesteuert, der das gegriffene und positionierte Bauteil BT freigbit und wieder ein neues Bauteil aufnehmen kann.

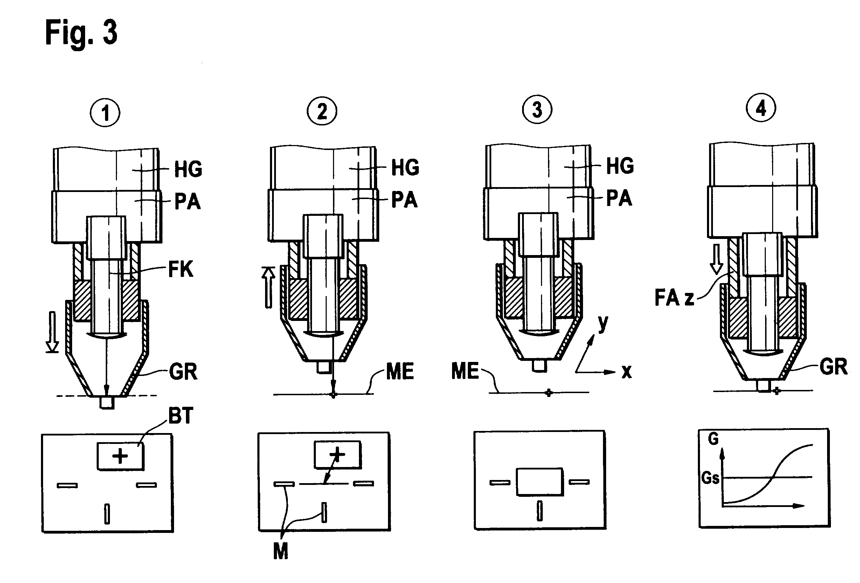

Wie Fig. 3 zeigt, läuft das Verfahren in mehreren Stufen ab. In der Stufe 1 wird das Bauteil BT vom Greifer GR gegriffen und mit der Kamera FK und der Bildverarbeitungseinrichtung BVE vermessen. Die Bauteilposition wird festgehalten.

In der Stufe 2 wird die Zielposition, d.h. die Fügeposition, vermessen, wobei die Positionen der Markierungen M auf der Montageebene ME ermittelt werden. Aus den gemessenen Positionen kann die Positionsabweichung ΔP ermittelt und der Korrekturweg Kw errechnet werden, so dass der iteraktive Grob-/Feinpositioniervorgang wie beschrieben ablaufen kann. Ist die Grob-/Feinpositionierung beendet, dann kann in der Stufe 4 der Fügeprozeß mit dem z-Achsen-Feinantrieb FA kraftgesteuert vorgenommen werden.

Das Greifersystem GRS ist mit dem Handhabungsgerät HG über ein Anschlußteil AP verbunden, das den Präzisionsantrieb PA drehfest trägt. An den Präzisionsantrieb PA schließt sich in Richtung zum Greifer GR die Kamera FK an, die als 1/3"-Miniaturkamera ausgebildet und wie der Präzisionsantrieb PA auf die Mittelachse = Fügeachse des Greifersystens GRS ausgerichtet ist. An die Kamera FK schließt sich ein Objektiv OB mit manueller Fokussierungseinrichtung MF an, in das Licht einer Lichtquelle koaxial eingeführt ist. Über einen Verlängerungstubus VT und einen Zwischenflansch ZF schließt sich der Kraftsensor KS an. Den Abschluß bildet ein weiterer Feinfokussierungsantrieb FKA, in den der als Sauggreifer SG ausgebildete Greifer GR eingesetzt ist. Der Sauggreifer sitzt in einem durchsichtigen Greifer GR, so daß über das Sichtfeld der Kamera FK das vom Greifer GR gegriffene Bauteil BT und auch die Markierungen M auf der Montageebene ME eingesehen werden können. Mit der manuellen Fokussiereinrichtung MF kann die Kalibrierung der Kamera FK und mit dem weiteren Feinfokussierantrieb FKA die Schärfeeinstellung in verschiedene Ebenen vorgenommen werden.

## Patentansprüche

1. Verfahren zum präzisen Positionieren und Fügen eines Bauteils auf einer Fügeposition einer Montageebene mittels eines Handhabungsgerätes mit Grob-Positionierantrieb eines Greifsystems mit Fein-Positionierantrieb sowie eines Meß- und Auswertesystems zum Ermitteln der Fügeposition und der Bauteil-Position des vom Greifer des Greifersystems gehaltenen Bauteils, zum Berechnen einer Positionsabweichung zwischen Fügeposition und Bauteil-Position und damit eines Korrrekturwertes zum Steuern des Grob- und Fein-Positionierantriebs,
dadurch gekennzeichnet,
dass als Meß- und Auswertesystem eine Kamera (FK) mit Meßobjektiv (OB) und eine Bildverarbeitungseinrichtung verwendet wird, wobei die Kamera (FK) und das Meßobjektiv (OB) außerhalb der Fügeposition (FP) und Bauteil-Position (BP) angeordnet werden,
dass Füge- und Bauteil-Position (FP, BP) entweder gleichzeitig oder nacheinander im Tiefenschärfebereich des Meßobjektes (OB) abgebildet und gemessen werden, wobei bei der nacheinander erfolgenden Abbildung und Messung das optische System (OS) zwischen den Messungen ortsfeset in der gleichen Meßebene in Bezug auf die erste Messung verbleibt,
dass bei einem ermittelten Korrekturwert (Kw) gleich oder größer als der maximale Stellweg (Swmax) des Fein-Positionsantriebes (PA) bei stillstehendem Fein-Positionierantrieb (PA) durch den Grob-Positionierantrieb des Handhabungsgerätes (HG) eine Lagekorrektur vorgenommen wird, bis eine verbleibende Positionierabweichung (APv) kleiner als der maximale Stellweg (Swmax) des Fein-Positionierantriebes (PA) erreicht ist,
dass nach Erreichen dieser verbleibenden Positionsabweichung (ΔPv) durch den Fein-Positionierantrieb (Pa) eine Endlagekorrektur mit einer zulässigen Fügetoleranz (Ft) durchgeführt wird und
dass danach der Fügevorgang eingeleitet und ausgeführt wird.

2. Verfahren nach Anspruch 1,
dadurch gekennzeichnet,
dass bei unterschiedlichem Meßabstand zwischen optischem System (OS) und der Fügeposition (FP) und der Bauteil-Position (BP) eine Anpassung durch eine Relativbewegung zwischen dem Bauteil (BT) im Greifer (SG) und dem Meßobjektiv (OB) vorgenommen wird.

3. Verfahren nach Anspruch 1 oder 2,
dadurch gekennzeichnet,
dass nach jeder Lagekorrektur durch den Grob-Positionierbetrieb des Handhabungsgerätes (HG) erneut eine Messung vorgenommen, die Positionsabweichung (ΔP) errechnet und eine weitere Lagekorrektur ausgeführt wird, bis der errechnete Korrekturwert (Kw) einer Lagekorrektur kleiner als der maximale Stellweg (Swmax) des Fein-Positionierantriebes (PA) entspricht.

4. Verfahren nach einem der Ansprüche 1 bis 3,
dadurch gekennzeichnet,
dass der Grob- und der Fein-Positionierantrieb als Mehrkoordinaten-Antriebe ausgebildet werden.

5. Verfahren nach einem der Ansprüche 1 bis 5,
dadurch gekennzeichnet,
dass der Grob-Positionierantrieb des Handhabungsgerätes (HG) mit großem Stellweg (Swmax) und kleiner Positioniergenauigkeit (z.B. ± 50 µm) und der Fein-Positionierantrieb (PA) des Greifersystems (GRS) mit kleinem Stellweg (Swmin) und großer Positioniergenauigkeit (z.B. ± 2 µm) ausgelegt werden.

6. Verfahren nach einem der Ansprüche 1 bis 5,
dadurch gekennzeichnet,
dass die Fügeposition (FP) aus Markierungen (M) der Montageebene (ME) ermittelt wird, die das Bauteil (BT) am Fügeort gleichförmig umschließen.

7. Verfahren nach einem der Ansprüche 1 bis 6,
dadurch gekennzeichnet,
dass die Winkelstellung des Bauteils (BT) in der Fügeachse (z.B. z-Achse) mittels des Grob-Positionierantriebes des Handhabungsgerätes (HG) eingestellt wird.

8. Verfahren nach einem der Ansprüche 1 bis 7,
dadurch gekennzeichnet,
dass der Fügeprozeß mittels eines Kraftsensors (KS) im Greifersystem (GRS) kraftgesteuert durchgeführt wird und beim Erreichen oder Überschreiten einer vorgegebenen Fügekraft (Gs) beendet wird.

9. Greifersystem zur Durchführung des Verfahrens nach einem oder mehreren der Ansprüche 1 bis 8,
dadurch gekennzeichnet,
dass es ein optisches System (OS) mit einer Kamera (FK) und einem Meßobjektiv (OB) und einer Einstellvorrichtung (MFK) zum Anpassen des Meßabstandes aufweist.

10. Greifersystem nach Anspruch 9,
dadurch gekennzeichnet,
dass das optische System (OS) eine Beleuchtungseinrichtung für das Kamera-Sichtfeld aufweist.

11. Greifersystem nach Anspruch 9 oder 10,
dadurch gekennzeichnet,
dass es mit einem Hubantrieb (FKA) versehen ist, mit dem eine Relativbewegung zwischen dem Meßobjektiv (OB) und dem Greifer (SG) ausführbar ist.

12. Greifersystem nach einem der Ansprüche 9 bis 11,
dadurch gekennzeichnet,
dass der Fein-Positionierantrieb (PA) mindestens in den Koordinaten x, y und 7 verstellbar ist.

13. Greifersystem nach einem der Ansprüche 9 bis 12,
dadurch gekennzeichnet,
dass der Greifer (SG) als Sauggreifer ausgebildet ist, der zumindest im Strahlengang, d.h. Sichtfeld des optischen Systems (OS), lichtdurchlässig, vorzugsweise glasklar ausgelegt ist.

14. Greifersystem nach einem der Ansprüche 9 bis 13,
dadurch gekennzeichnet,
dass der Greifer (SG) über einen Kraftsensor (KS) am Greifersystem (GRS) abgestützt ist.

15. Greifersystem nach einem der Ansprüche 9 bis 14,
dadurch gekennzeichnet,
dass die Kamera (FK) als Miniaturkamera und der Fein-Positionierantrieb als Piezoantrieb ausgebildet sind.

16. Greifersystem nach einem der Ansprüche 9 bis 15,
dadurch gekennzeichnet,
dass die Kamera (FK), das Meßobjektiv (OB), die Beleuchtungseinrichtung und der Kraftsensor (KS) in das Greifersystem (GRS) integriert sind.
